# DEMANDE DE BREVET EUROPEEN

(11) **EP 2 015 448 A1**
(43) Date de publication de la demande: **14.01.2009**
(21) Numéro de dépôt: 08159986.2
(22) Date de dépôt: 09.07.2008
(51) Int. Cl.: H03H 7/01, H03H 7/24, H04B 3/14

(54) **Chaîne d'acquisition de signaux comportant un attenuateur selectif en fréquences**

(30) Priorité: 10.07.2007 FR 0704993
(71) Demandeur: Thales, 92200 Neuilly sur Seine (FR)
(72) Inventeur: FUCHE, Loïc, 49360, MAULEVRIER (FR); BARTHELEMY, Claude, 49300, CHOLET (FR)
(74) Mandataire: Lucas, Laurent Jacques

(57) **Abrégé**

La présente invention concerne une chaîne d'acquisition de signaux comportant un atténuateur sélectif en fréquences comprenant au moins un module atténuateur (102) pourvu au moins d'une entrée (102a), d'une sortie (102c) et d'un troisième accès (102b, 102d), un module de réjection centré sur une ou plusieurs fréquences F₀, F₁ et disposé entre l'entrée (102a) et la sortie (102c) du module atténuateur, et un autre module de réjection centré sensiblement sur les mêmes fréquences F₀, F₁ et placé entre le troisième accès (102b, 102d) et une masse électrique, les modules de réjection fonctionnant en opposition l'un par rapport à l'autre selon deux modes : un mode circuit ouvert ou un mode court-circuit. L'invention s'applique notamment aux chaînes de réception radioélectriques pour réduire la puissance de signaux présents dans certaines bandes de fréquence.

## Description

La présente invention concerne une chaîne d'acquisition de signaux comportant un atténuateur sélectif en fréquences. Elle s'applique notamment aux chaînes de réception radioélectriques pour réduire la puissance de signaux présents dans certaines bandes de fréquence.

Les récepteurs radioélectriques modernes sont conçus pour traiter des bandes fréquentielles d'acquisition de plus en plus larges par rapport à la canalisation des signaux. Une des difficultés rencontrées dans la réalisation des chaînes de réception est l'acquisition d'un signal de faible niveau en présence de signaux à forts niveaux, tout en conservant de l'information sur les signaux forts. Avec l'émergence des nouvelles générations de récepteurs numériques, ce problème doit notamment être traité pour la numérisation directe de larges bandes de fréquences dans les chaînes de réception numériques. En effet, il est toujours possible d'amplifier de faibles signaux, mais cette solution se heurte aux limites des convertisseurs analogique-numérique (CAN) qui n'acceptent qu'une tension limitée en entrée. Par exemple, un récepteur à numérisation directe doit pouvoir numériser une bande de fréquences comprises entre 1 et 30 MHz, chaque signal étant canalisé sur un canal de 3kHz, le tout dans un environnement spectral perturbé par des signaux forts. A titre d'exemple, les signaux émis sur les bandes de radiodiffusion ou de télédiffusion, souvent qualifiées par le terme anglo-saxon de bandes de broadcast, sont particulièrement puissants et peuvent être considérés comme des signaux brouilleurs vis à vis des signaux hors broadcast. Afin de permettre au CAN d'exploiter pleinement la plage de tensions acceptées en entrée lors de l'échantillonnage de l'ensemble des signaux d'une large bande de fréquences, il est souhaitable de diminuer la puissance de ces signaux forts.

Actuellement, il est connu d'utiliser des atténuateurs pour diminuer la puissance de signaux. Cependant, les atténuateurs sont des fonctions invariantes en fréquence ce qui signifie que l'ensemble des signaux du spectre subit l'atténuation. Or, généralement, il ne faut pas atténuer les signaux faibles sous peine de ne plus pouvoir les traiter par la suite. Une combinaison d'atténuateurs et d'amplificateurs n'aboutirait qu'à une augmentation du facteur de bruit, et serait donc sans effet bénéfique.

Il est également connu d'éliminer les signaux perturbateurs présents sur une bande de fréquences donnée en utilisant des filtres réjecteurs de type Notch, lesquels rejettent une bande de fréquence tout en laissant passer le reste du spectre. Ces filtres sont particulièrement volumineux et coûteux. De plus, l'utilisation de ce type de filtre rend impossible tout traitement de signaux dans la bande de fréquences rejetée. En effet, les filtres Notch présentent un Rapport d'Ondes Stationnaires (ROS) très supérieur à 1 dans la bande de fréquence rejetée et introduisent donc des discontinuités de phase qui empêchent d'effectuer certains types de traitements, notamment les calculs goniométriques. Par ailleurs, cette mauvaise adaptation d'impédance sur une portion du spectre fréquentiel empêche la mise en cascade de ces filtres, ce qui s'avère gênant lorsque l'on souhaite éliminer plusieurs signaux indésirables de fréquences différentes.

Un but de l'invention est d'atténuer la puissance de signaux présents sur certaines portions d'une bande de fréquence sans affecter les signaux occupant les autres parties du spectre, et en permettant le traitement des signaux atténués. A cet effet, l'invention a pour objet une chaîne d'acquisition de signaux, caractérisée en ce qu'elle comporte au moins un atténuateur sélectif en fréquences de la puissance d'un signal entrant, l'atténuateur sélectif comportant au moins un module atténuateur de puissance pourvu au moins d'une entrée, d'une sortie et d'un troisième accès, une paire de modules de réjection, un desdits modules étant centré sur une ou plusieurs fréquences F₀, F₁ et disposé entre l'entrée et la sortie du module atténuateur de puissance, et un autre des modules de réjection étant centré sensiblement sur les mêmes fréquences F₀, F₁ et placé entre le troisième accès et une masse électrique, les modules de réjection fonctionnant selon deux modes :
o lorsque la fréquence du signal entrant est proche de l'une des fréquences de réjection F₀, F₁, un premier module de réjection de la paire bascule en mode circuit ouvert, un second module de réjection de la paire bascule en mode court-circuit,
o lorsque la fréquence du signal entrant est éloignée des fréquences de réjection F₀, F₁, le second module de réjection de la paire bascule en mode circuit ouvert, le premier module de réjection de la paire bascule en mode court-circuit.

Selon un mode de réalisation, le module atténuateur de puissance et les modules de réjection de l'atténuateur sélectif sont des quadripôles, l'un des modules de réjection de la paire étant monté en parallèle avec le module atténuateur de puissance pour former un troisième quadripôle, ledit troisième quadripôle étant monté en série avec l'autre module de réjection de la paire.

Selon un mode de réalisation, le premier module de réjection de l'atténuateur sélectif comporte au moins un circuit RLC parallèle et le second module de réjection de l'atténuateur sélectif comporte au moins un circuit RLC série, les fréquences d'accord des circuits RLC étant égales aux fréquences de réjection.

Selon un autre mode de réalisation, le premier module de réjection de l'atténuateur sélectif comporte au moins un circuit RLC série et le second module de réjection de l'atténuateur sélectif comporte au moins un circuit RLC parallèle, les fréquences d'accord des circuits RLC étant égales aux fréquences de réjection.

Selon un mode de réalisation, au moins un circuit RLC série et au moins un circuit RLC parallèle comporte une diode à capacité variable pour faire varier la fréquence d'accord F₀.

Selon un mode de réalisation, la chaîne d'acquisition selon l'invention est adaptée à recevoir et à traiter des signaux radioélectriques dans la bande HF.

Selon un mode de réalisation, la chaîne d'acquisition de signaux selon l'invention est réversible, celle-ci étant adaptée à recevoir et à émettre des signaux transitant par l'atténuateur sélectif en fréquences.

Une chaîne de réception radiofréquences comportant un atténuateur sélectif en fréquences peut, par exemple, être utilisée pour diminuer l'amplitude de signaux émis sur des bandes de broadcast déjà connues.

D'autres caractéristiques apparaîtront à la lecture de la description détaillée donnée à titre d'exemple et non limitative qui suit faite en regard de dessins annexés qui représentent :
- la figure 1, un exemple de structure d'atténuateur sélectif en fréquences utilisé dans une chaîne d'acquisition selon l'invention,
- la figure 2, un premier mode de réalisation d'un atténuateur sélectif en fréquences utilisé dans une chaîne d'acquisition selon l'invention,
- la figure 3, une courbe d'atténuation de puissance correspondant au premier mode de réalisation,
- la figure 4, un deuxième mode de réalisation, permettant d'obtenir une fonction d'atténuation duale de celle de la figure 3,
- la figure 5, une courbe d'atténuation de puissance correspondant au deuxième mode de réalisation,
- la figure 6, une généralisation de la structure d'atténuateur sélectif en fréquences présentée en figure 1,
- la figure 7, un troisième mode de réalisation d'un atténuateur sélectif en fréquences utilisé dans une chaîne d'acquisition selon l'invention comportant deux zones d'atténuation,
- la figure 8, une courbe d'atténuation de puissance correspondant au troisième mode de réalisation,
- la figure 9, une généralisation de la structure d'atténuateur sélectif en fréquences présentée en figure 4,
- la figure 10, un quatrième mode de réalisation d'un atténuateur sélectif en fréquences utilisé dans une chaîne d'acquisition selon l'invention comportant deux zones de non-atténuation,
- la figure 11, une courbe d'atténuation de puissance correspondant au quatrième mode de réalisation,
- la figure 12, un synoptique d'une chaîne de réception radiofréquence selon l'invention comportant un atténuateur sélectif en fréquences.

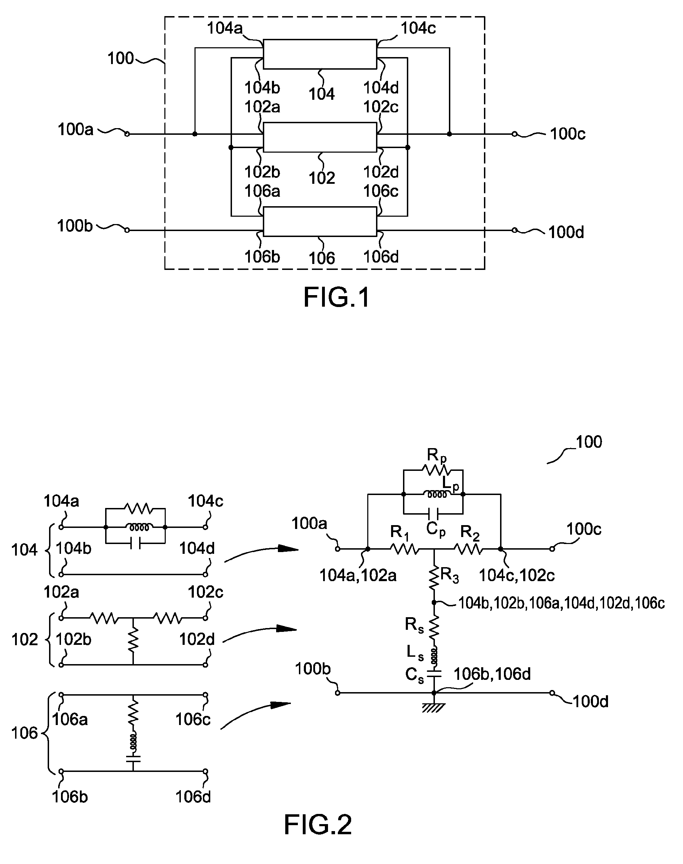

La figure 1 présente un exemple de structure d'atténuateur sélectif en fréquences utilisé dans une chaîne d'acquisition selon l'invention. L'atténuateur sélectif en fréquences 100 est, dans l'exemple, un quadripôle comportant trois quadripôles : deux réjecteurs 104, 106 et un atténuateur de puissance 102. Le premier réjecteur 104 est monté en parallèle avec l'atténuateur de puissance 102, formant ainsi un quadripôle, lequel est monté en série avec le second réjecteur 106.

Pour préciser la description, l'atténuateur sélectif en fréquences 100 comporte deux entrées 100a, 100b et deux sorties 100c, 100d, le premier réjecteur 104 comporte deux entrées 104a, 104b et deux sorties 104c et 104d, le second réjecteur 106 comporte deux entrées 106a, 106b et deux sorties 106c, 106d, et l'atténuateur de puissance 102 comporte deux entrées 102a, 102b et deux sorties 102c, 102d. La première entrée 104a du premier réjecteur 104 est reliée à la première entrée 1 02a de l'atténuateur de puissance 102, ces deux entrées 104a, 102a étant reliées à la première entrée 100a de l'atténuateur sélectif en fréquences 100. La première sortie 104c du premier réjecteur 104 est reliée à la première sortie 102c de l'atténuateur de puissance 102, ces deux sorties 104c, 102c étant reliées à la première sortie 100c de l'atténuateur sélectif en fréquences 100. La seconde entrée 104b du premier réjecteur 104 est reliée à la seconde entrée 102b de l'atténuateur de puissance 102 et à la première entrée 106a du deuxième réjecteur 106. La seconde sortie 104d du premier réjecteur 104 est reliée à la seconde sortie 102d de l'atténuateur de puissance 102 et à la première sortie 106c du second réjecteur 106. La seconde entrée 106b du second réjecteur 106 est reliée à la seconde entrée 100b de l'atténuateur sélectif en fréquences 100 et la seconde sortie 106d du second réjecteur 106 est reliée à la seconde sortie 100d de l'atténuateur sélectif en fréquences 100.

L'atténuateur de puissance 102 a notamment pour effet de diminuer la puissance d'un signal entrant. Cette fonction est invariante en fréquences, autrement dit, l'atténuateur de puissance 102 atténue la puissance d'un signal entrant de la même manière quelque soit la fréquence de ce signal. Le premier et le second réjecteur 104, 106 sont conçus pour fonctionner en concomitance et de manière complémentaire. Par exemple, lorsque le premier réjecteur 104 établit un court-circuit entre les premières entrée et sortie 100a, 100c de l'atténuateur sélectif en fréquences 100, le second réjecteur 106 isole lesdites entrée et sortie des secondes entrées et sorties 100b, 100d. Les deux réjecteurs 104, 106 sont réalisés pour que la puissance transmise par chacun d'entre eux évolue de manière complémentaire en fonction de la fréquence du signal d'entrée. Par exemple, les deux réjecteurs 104, 106 peuvent être accordés sur une même fréquence F₀, de telle sorte qu'un signal entrant dans l'atténuateur sélectif en fréquences 100, dont la fréquence est proche de F₀, soit très fortement atténué en sortie 100c, 100d et qu'un signal entrant dont la fréquence est éloignée de F₀ soit transmis quasiment sans atténuation en sortie.

L'atténuateur sélectif 100 est réalisé de sorte que ses impédances d'entrée et de sortie soient maîtrisées. Par exemple, pour une chaîne de réception de signaux radioélectriques, on choisit généralement une valeur d'impédance égale à 50 ohms. Généralement, le niveau d'atténuation de l'atténuateur de puissance 102 est choisi dans un premier temps, puis les valeurs des fréquences de réjection des deux réjecteurs 104, 106 sont choisies.

La mise en place d'un atténuateur sélectif 100 dans une chaîne d'acquisition de signaux, par exemple une chaîne d'acquisition de signaux radioélectriques, permet d'atténuer des signaux perturbateurs sans en dégrader le contenu informatif, de sorte que les signaux atténués peuvent encore être analysés, contrairement à un circuit égalisateur, qui se comporte comme un compensateur de niveau.

La figure 2 présente un premier mode de réalisation d'un atténuateur sélectif en fréquences utilisé dans une chaîne d'acquisition selon l'invention. Dans l'exemple, le premier réjecteur 104 est un quadripôle comportant un circuit RLC parallèle. Ainsi, un circuit RₚLₚCₚ formé d'une résistance Rp, d'une inductance Lp et d'une capacité Cp montées en parallèle relie la première entrée 104a à la première sortie 104c du premier quadripôle réjecteur 104. La seconde entrée 104b est reliée à la seconde sortie 104d par un fil.

Selon l'exemple de la figure 2, la première entrée 106a du second réjecteur 106 est reliée à sa première sortie 106c par un fil, de même que sa seconde entrée 1 06b est reliée par un fil à la seconde sortie 106d. Un circuit RₛLₛCₛ, formé par une résistance Rₛ, une inductance Lₛ, et une capacité Cₛ montées en série, est placé entre les premières entrée et sortie 106a, 106c et les secondes entrée et sortie 106b, 106d. Dans l'exemple, les secondes entrée et sortie 106b, 106d du second réjecteur sont mises à la masse électrique.

L'atténuateur de puissance 102 présenté en figure 2 est un atténuateur en T, comportant deux résistances R1, R2 placées en série entre la première entrée 102a et la première sortie 102c. L'atténuateur de puissance 102 comporte également une troisième résistance R3 reliant la jonction des deux premières résistances R1, R2 avec les secondes entrée et sortie 102b, 102d, lesdites entrée et sortie étant reliées entre-elles par un fil. Selon un autre mode de réalisation, l'atténuateur de puissance 102 présente une structure en Π.

Les circuits RLC présents dans le premier et le second réjecteur 104, 106 sont conçus pour avoir sensiblement la même fréquence d'accord F₀. Par ailleurs, les valeurs des inductances et capacités de ces circuits RₚLₚCₚ, RₛLₛCₛ ont un impact sur le facteur de qualité, c'est à dire la sélectivité du filtre. D'une part, la fréquence d'accord du circuit RₚLₚCₚ du premier réjecteur 104 est fonction du produit Lp.Cp. D'autre part, la fréquence d'accord du circuit RₛLₛCₛ du second réjecteur 106 est fonction du produit Lₛ.Cₛ. Ainsi, les couples de valeurs (Lₚ,Cₚ) et (Lₛ.Cₛ) sont notamment déterminés en fonction de la fréquence d'accord F₀ visée et de la sélectivité souhaitée. Dans l'exemple, la fréquence F₀ correspond à la fréquence des signaux perturbateurs à atténuer et la sélectivité correspond à la bande de fréquence à couvrir autour de cette fréquence F₀. La résistance série Rₛ est la résistance de perte due notamment à l'aspect résistif de l'inductance série Lₛ. La valeur de cette résistance en série Rₛ dépend de la valeur du coefficient de qualité de l'inductance série Lₛ. L'inductance Lₛ est choisie afin que la valeur Rₛ soit quasi-nulle. De manière analogue, la valeur de la résistance en parallèle Rp dépend de la valeur du coefficient de qualité de l'inductance parallèle Lp, laquelle est choisie pour que la valeur Rp soit très supérieure aux valeurs des résistances R1, R2, et R3 de l'atténuateur de puissance 102. A titre d'exemple, pour un atténuateur sélectif en fréquences 100 dont la fréquence d'accord F₀ est approximativement égale à 7.5 MHz, dont la largeur de la bande atténuée est d'environ 300 kHz, avec une atténuation de 14 dB à F₀, les valeurs suivantes pourront être utilisées : R1=33 ohms, R2=33 ohms, R3=21 ohms, Rₚ=1000 ohms, Lp=33.77 nH, Cp=13.35 nF, Rₛ≈0 ohm, Lₛ=33.17 µH, Cₛ=13.59 pF.

Selon un autre mode de réalisation, les réjecteurs peuvent comporter plusieurs inductances et/ou plusieurs capacités afin d'obtenir une sélectivité de réjection plus importante. Dans ce cas, les inductances appartenant à un même réjecteur peuvent être alignées lors de l'implantation matérielle afin de créer une mutuelle inductance.

Les capacités Cₛ, Cp utilisées dans les circuits RLC peuvent être fixes ou variables. Ces capacités sont accordables par courant ou par tension. Par exemple, pour faire varier la fréquence d'accord F₀, une diode à capacité variable peut être utilisée.

Dans le domaine des hyperfréquences, les circuits RLC peuvent être remplacés par d'autres circuits résonnants comportant, par exemple, des barreaux de céramique.

Lorsque la fréquence du signal entrant est nettement inférieure à la fréquence d'accord F₀, le premier réjecteur 104 tend à court-circuiter sa première entrée 104a avec sa première sortie 104c, grâce à l'impédance quasi-nulle de l'inductance Lp aux basses fréquences. Concomitamment, le second réjecteur tend à ouvrir le circuit entre ses premières entrée et sortie 106a, 106c et ses secondes entrée et sortie 106b, 106d, la capacité Cₛ bloquant le passage du courant électrique aux basses fréquences. Ainsi, lorsque la fréquence du signal entrant est nettement inférieure à F₀, l'atténuateur sélectif en fréquences 100 tend à se comporter comme une simple ligne de transmission, laissant passer le signal sans le modifier notablement.

Lorsque la fréquence du signal entrant est nettement supérieure à F₀, le premier réjecteur 104 tend à court-circuiter sa première entrée 104a avec sa première sortie 104c, grâce à l'impédance quasi-nulle de la capacité Cp aux fréquences hautes. Concomitamment, le second réjecteur tend à ouvrir le circuit entre ses premières entrée et sortie 106a, 106c et ses secondes entrée et sortie 106b, 106d, l'inductance Lₛ bloquant le passage du courant électrique aux fréquences hautes. Ainsi, lorsque la fréquence du signal entrant est nettement supérieure à F₀, l'atténuateur sélectif en fréquences 100 tend à se comporter comme une simple ligne de transmission, laissant passer le signal sans le modifier notablement.

Lorsque la fréquence du signal entrant est proche de la fréquence d'accord F₀, le circuit RₚLₚCₚ du premier réjecteur 104 se comporte sensiblement comme un circuit ouvert vis à vis de l'atténuateur de puissance 102, puisque la résistance parallèle Rp est très supérieure aux résistances composant l'atténuateur 102. Parallèlement, au niveau du circuit RₛLₛCₛ série du second réjecteur 106, un court-circuit est quasiment opéré entre l'atténuateur de puissance 102 et la masse électrique, car la résistance série Rₛ est très faible. Ainsi lorsque la fréquence du signal entrant est proche de F₀, l'influence des deux circuits réjecteurs 104, 106 est largement inhibée et l'atténuateur sélectif en fréquences 100 se comporte sensiblement comme un atténuateur classique.

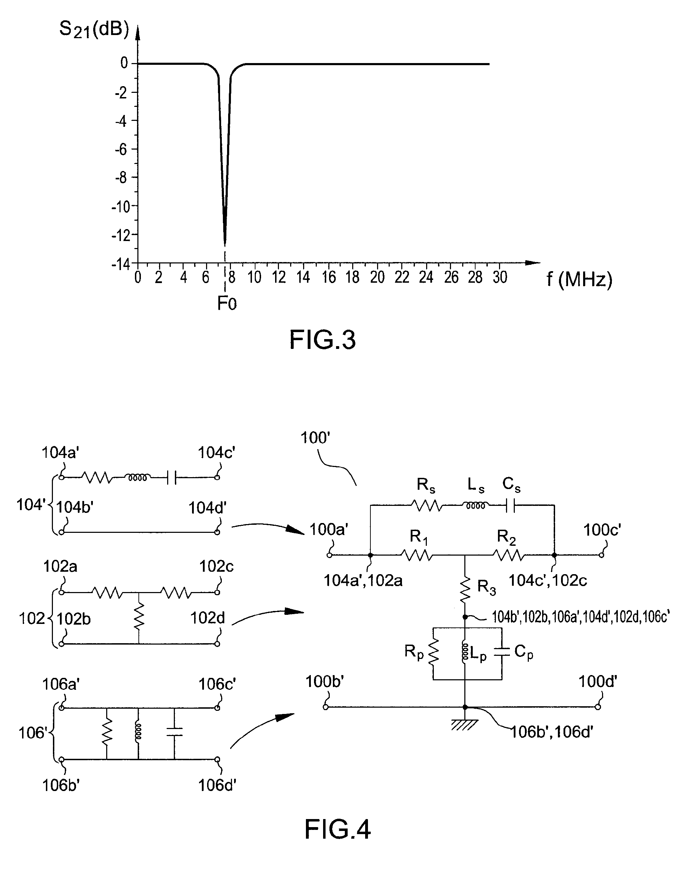

La figure 3 illustre, par une courbe, l'évolution du coefficient de transmission directe S21 de l'atténuateur sélectif en fréquences selon le premier mode de réalisation présenté en figure 2 en fonction de la fréquence du signal entrant. Grâce à l'association des deux réjecteurs 104, 106 autour de l'atténuateur 102, seuls les signaux dont la fréquence est proche de la fréquence F₀ sont atténués, le reste du spectre fréquentiel n'étant pas altéré. En outre, le ROS, non représenté sur la figure, reste quasiment égal à 1 quelque soit la fréquence du signal d'entrée et la phase des signaux est peu modifiée. Par ailleurs, le coefficient de réflexion S11 est proche de l'impédance caractéristique du quadripôle atténuateur sélectif1 00.

La figure 4 présente un deuxième mode de réalisation d'un atténuateur sélectif en fréquences utilisé dans une chaîne d'acquisition selon l'invention. Dans ce mode de réalisation, l'objectif recherché est d'atténuer les signaux de toutes fréquences, à l'exception de ceux dont la fréquence est proche de la fréquence d'accord F₀. La fonction recherchée est donc la fonction duale de la fonction de transmission illustrée en figure 3. Dans ce deuxième mode de réalisation, l'atténuateur sélectif en fréquences 100' comprend deux réjecteurs 104', 106'. Le premier réjecteur 104' comporte un circuit RₛLₛCₛ série placé en parallèle de l'atténuateur de puissance 102, tandis que le second réjecteur 106' comporte un RₚLₚCₚ parallèle placé en série avec l'atténuateur de puissance 102. Par rapport au premier mode de réalisation présenté en figure 2, le premier quadripôle réjecteur 104 et le deuxième quadripôle réjecteur 106 ont chacun été remplacés respectivement par leur quadripôle dual 104' et 106'.

De manière plus détaillée, le premier réjecteur 104' comporte un circuit RₛLₛCₛ série placé entre sa première entrée 104a' et sa première sortie 104c', tandis que les secondes entrée et sortie 104b', 104d' sont reliées par un fil. Le second réjecteur 106' comporte un circuit RₚLₚCₚ parallèle placé entre les premières entrée et sortie 106a', 106c' et les secondes entrée et sortie 1 06b', 1 06d', la première entrée 106a' étant reliée par un fil à la première sortie 106c' et la seconde entrée 106b' étant également reliée par un fil à la seconde sortie 106d'.

Lorsque la fréquence du signal entrant est nettement inférieure à la fréquence d'accord F₀, le circuit RₛLₛCₛ série du premier réjecteur 104' se comporte quasiment comme un circuit ouvert du fait de la présence de la capacité Cₛ. Parallèlement, le circuit RₚLₚCₚ du second réjecteur 106' se comporte quasiment comme un court-circuit du fait de la présence de l'inductance Lp. Ainsi lorsque la fréquence du signal entrant est nettement inférieure à la fréquence d'accord F₀, l'influence des deux circuits réjecteurs 104', 106' est largement inhibée et l'atténuateur sélectif en fréquences 100' se comporte sensiblement comme un atténuateur classique.

Lorsque la fréquence du signal entrant est nettement supérieure à la fréquence d'accord F₀, le circuit RₛLₛCₛ série du premier réjecteur 104' se comporte quasiment comme un circuit ouvert du fait de la présence de l'inductance Lₛ. Parallèlement, le circuit RₚLₚCₚ du second réjecteur 106' se comporte quasiment comme un court-circuit du fait de la présence de la capacité Cp. Ainsi lorsque la fréquence du signal entrant est nettement supérieure à la fréquence d'accord F₀, l'influence des deux circuits réjecteurs 104', 106' est largement inhibée et l'atténuateur sélectif en fréquences 100' se comporte sensiblement comme un atténuateur classique.

Lorsque la fréquence du signal entrant est proche de la fréquence d'accord F₀, le premier circuit réjecteur 104' tend à court-circuiter sa première entrée 104a' avec sa première sortie 104c', puisque la résistance Rₛ du circuit RₛLₛCₛ série est très faible. Concomitamment, le circuit RₚLₚCₚ du second réjecteur 106' oppose une résistance Rp importante au passage du courant. Ainsi, lorsque la fréquence du signal entrant est proche de la fréquence d'accord F₀, l'atténuateur sélectif en fréquences 100' tend à se comporter comme une simple ligne de transmission, laissant passer le signal sans le modifier notablement.

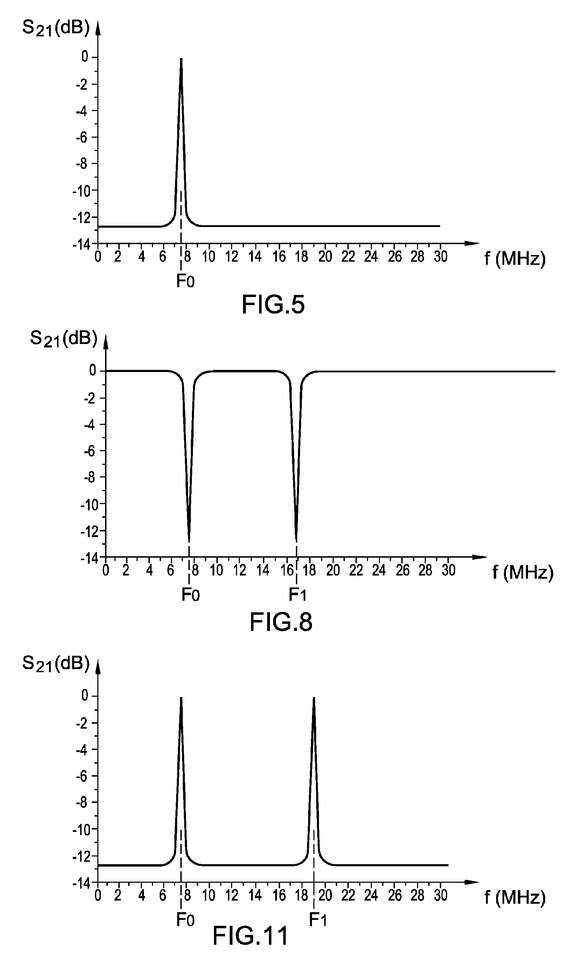

La figure 5 illustre, par une courbe, l'évolution du coefficient de transmission directe S21 de l'atténuateur sélectif en fréquences selon le deuxième mode de réalisation présenté en figure 4 en fonction de la fréquence du signal entrant. A l'exception d'une bande de fréquence autour de F₀, les signaux de toutes les fréquences sont atténués. En outre, de même que pour le premier mode de réalisation, le ROS demeure, dans le cas de cette mode de réalisation, quasiment égal à 1 quelque soit la fréquence du signal d'entrée et la phase des signaux est peu modifiée, y compris autour de la fréquence d'accord F₀. Par ailleurs, le coefficient de réflexion S11 est proche de l'impédance caractéristique du quadripôle atténuateur sélectif 100.

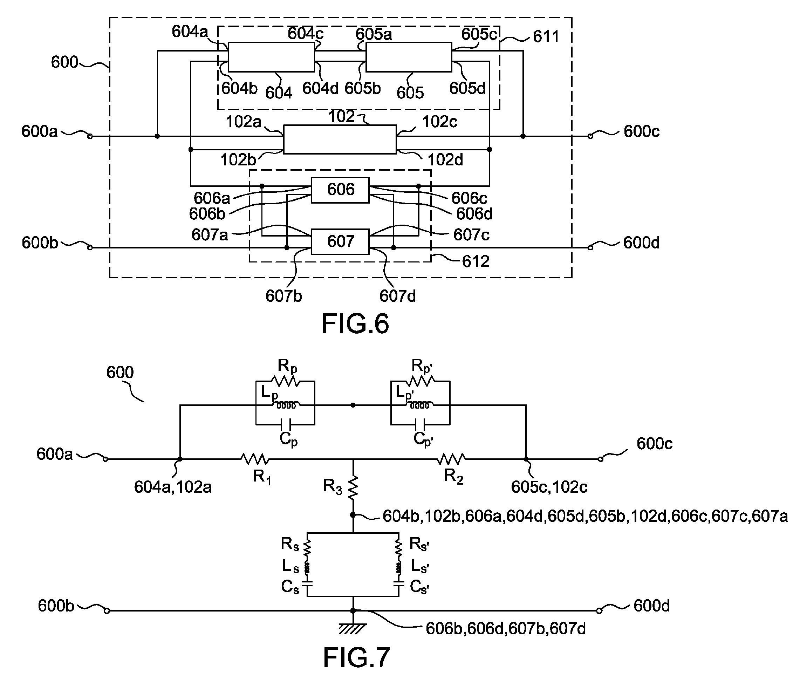

La figure 6 présente une généralisation de la structure d'atténuateur sélectif en fréquences présentée en figure 1. Pour créer plusieurs zones fréquentielles d'atténuation, il est possible d'associer plusieurs réjecteurs. Par exemple, la figure 6 illustre un atténuateur sélectif en fréquences comportant deux zones fréquentielles d'atténuation. Ainsi, l'atténuateur sélectif en fréquences 600 comporte un premier module de réjection 611 comprenant deux quadripôles réjecteurs 604, 605 montés en cascade, ledit module étant monté en parallèle avec un atténuateur de puissance 102. Un deuxième module de réjection 612 comprend deux quadripôles réjecteurs 606, 607 montés en parallèle, ce deuxième module étant monté en série avec l'atténuateur de puissance 102.

Plus précisément, la première sortie 604c du premier quadripôle réjecteur 604 est reliée à la première entrée 605a du deuxième quadripôle 605 et la seconde sortie 604d du premier quadripôle réjecteur 604 est reliée à la seconde entrée 605b du deuxième quadripôle 605. Le premier module de réjection 611 ainsi formé remplace le quadripôle réjecteur 104 de la figure 1. Selon le même principe, le deuxième module de réjection 612 remplace le second quadripôle réjecteur 106 de la structure de la figure 1, les autres connexions étant identiques à celles du premier mode de réalisation.

Cet exemple n'est pas limitatif. Par exemple, un plus grand nombre de réjecteurs peuvent être associés en cascade et en parallèle. Les réjecteurs sont associés par paires, chaque paire correspondant à une zone fréquentielle d'atténuation de la puissance. Pour ajouter une telle zone d'atténuation dans le spectre, il faut donc ajouter une nouvelle paire de réjecteurs, le premier desquels étant monté en cascade avec les réjecteurs 604, 605 du premier module de réjection 611, et le second étant monté en parallèle avec les réjecteurs 606, 607 du second module de réjection 612.

La figure 7 présente un mode de réalisation correspondant à la structure généralisée de la figure 6. Dans cet exemple, deux zones fréquentielles d'atténuation sont obtenues, c'est pourquoi l'atténuateur sélectif en fréquences 600 comporte deux paires de réjecteurs. Les quadripôles réjecteurs 604, 605 reliés aux premières entrée et sortie 600a, 600c de l'atténuateur sélectif en fréquences 600 sont, dans l'exemple, les mêmes que le premier quadripôle réjecteur 104 de la figure 2. Les quadripôles réjecteurs 606, 607 reliés aux secondes entrée et sortie 600b, 600d de l'atténuateur sélectif en fréquences 600 sont, dans l'exemple, les mêmes que le second quadripôle réjecteur 106 de la figure 2. Cet atténuateur sélectif en fréquences 600 se distingue donc du premier mode de réalisation présenté en figure 2 par l'ajout de deux circuits RLC. Un circuit Rₚ'Lₚ'Cₚ' parallèle est associé en série au circuit RₚLₚCₚ déjà présent dans le premier réjecteur 104 et un circuit Rₛ'Lₛ'Cₛ' série est monté en parallèle avec le circuit RₛLₛCₛ déjà présent dans le second réjecteur 106. Chaque paire de circuits RₛLₛCₛ/RₚLₚCₚ et Rₛ'Lₛ'Cₛ'/Rₚ'Lₚ'Cₚ' fonctionne indépendamment l'une de l'autre la première paire RₛLₛCₛ/RₚLₚCₚ fonctionnant à une fréquence d'accord F₀, et la seconde paire Rₛ'Lₛ'Cₛ'/Rₚ'Lₚ'Cₚ' fonctionnant à une autre fréquence d'accord F₁. D'une part, la mise en cascade des circuits RₚLₚCₚ, Rₚ'Lₚ'Cₚ' permet d'effectuer un « ou » logique sur la fonction d'ouverture du circuit entre les première entrée et sortie 102a, 102c de l'atténuateur de puissance 102. D'autre part, la mise en parallèle des circuits RₛLₛCₛ, Rₛ'Lₛ'Cₛ' série permet d'effectuer un « ou » logique sur la fonction de court-circuitage des secondes entrée et sortie 102b, 102d de l'atténuateur de puissance 102 avec la masse électrique. Ainsi, l'atténuateur sélectif en fréquences 600 atténue seulement les signaux dont les fréquences sont proches des fréquences F₀ et F₁.

La figure 8 illustre, par une courbe, l'évolution du coefficient de transmission directe S21 de l'atténuateur sélectif en fréquences selon le troisième mode de réalisation présenté en figure 7 en fonction de la fréquence du signal entrant. A l'exception d'une bande de fréquence autour de F₀ et de F₁, les signaux de toutes les fréquences sont atténués.

Afin d'atténuer un plus grand nombre de bandes de fréquences, il est également possible d'associer plusieurs atténuateurs sélectifs en fréquences en série, chacun desdits atténuateurs étant conçu pour atténuer une ou plusieurs bandes de fréquences.

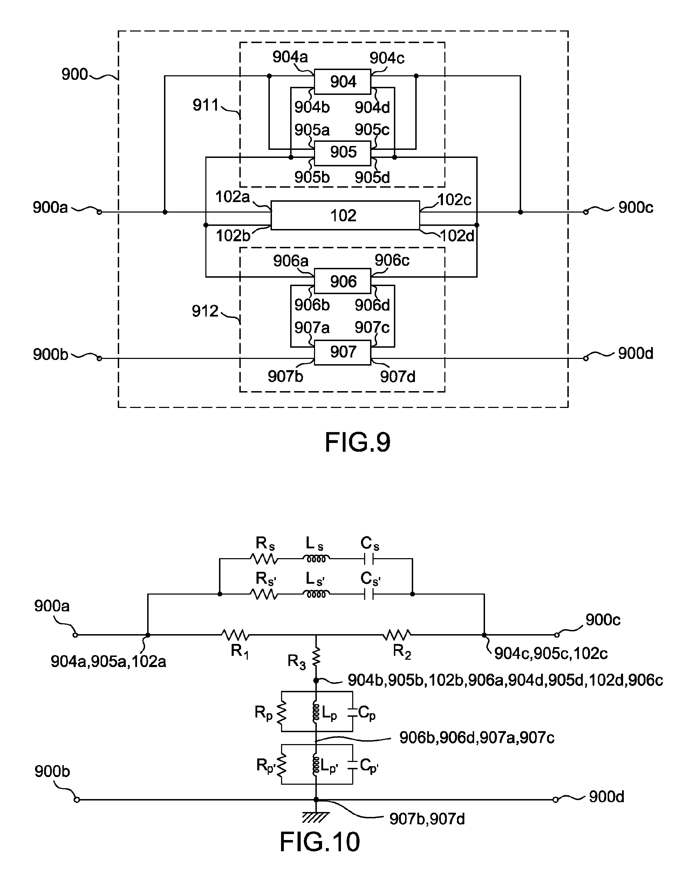

La figure 9 présente une structure d'atténuateur sélectif en fréquences permettant d'obtenir une fonction d'atténuation duale de celle présentée en figure 8. L'objectif recherché est d'atténuer les signaux de l'ensemble du spectre à l'exception de deux zones pour lesquelles les signaux ne sont pas atténués. L'atténuateur sélectif en fréquences 900 comporte un premier module de réjection 911 comprenant deux quadripôles réjecteurs 904, 905 montés en parallèle, ledit module étant monté en parallèle avec un atténuateur de puissance 102. Un deuxième module de réjection 912 comprend deux quadripôles réjecteurs 906, 907 montés en série, ce deuxième module étant monté en série avec l'atténuateur de puissance 102.

La figure 10 présente un mode de réalisation correspondant à la structure de la figure 9. Les quadripôles réjecteurs 904, 905 reliés aux premières entrée et sortie 900a, 900c de l'atténuateur sélectif en fréquences 900 sont, dans l'exemple, les mêmes que le premier quadripôle réjecteur 104' de la figure 4. Les quadripôles réjecteurs 906, 907 reliés aux secondes entrée et sortie 900b, 900d de l'atténuateur sélectif en fréquences 900 sont, dans l'exemple, les mêmes que le second quadripôle réjecteur 106' de la figure 4. Cet atténuateur sélectif en fréquences 900 se distingue donc du premier mode de réalisation présenté en figure 4 par l'ajout de deux circuits RLC. Un premier circuit Rₛ'Lₛ'Cₛ' série est monté en parallèle avec le circuit RₛLₛCₛ déjà présent dans le premier réjecteur 104' et un second circuit Rₚ'Lₚ'Cₚ' parallèle est associé en série au circuit RₚLₚCₚ déjà présent dans le second réjecteur 106'. Chaque paire de circuits RₛLₛCₛ/RₚLₚCₚ et Rₛ'Lₛ'Cₛ'/Rₚ'Lₚ'Cₚ' fonctionne indépendamment l'une de l'autre la première paire RₛLₛCₛ/RₚLₚCₚ correspondant à une fréquence d'accord F₀, et la seconde paire Rₛ'Lₛ'Cₛ'/Rₚ'Lₚ'Cₚ' correspondant à une autre fréquence d'accord F₁. D'une part, la mise en série des circuits RₚLₚCₚ, Rₚ'Lₚ'Cₚ' permet d'effectuer un « ou » logique sur la fonction d'ouverture du circuit entre les secondes entrée et sortie 1 02b, 102d de l'atténuateur de puissance 102 et la masse électrique. D'autre part, la mise en parallèle des circuits RₛLₛCₛ, Rₛ'Lₛ'Cₛ' série permet d'effectuer un « ou » logique sur la fonction de court-circuitage des première entrée et sortie 102a, 102c de l'atténuateur de puissance 102. Ainsi, les seuls signaux non atténués par l'atténuateur sélectif en fréquences 900 sont ceux dont les fréquences sont proches des fréquences F₀ et F₁.

La figure 11 illustre, par une courbe, l'évolution du coefficient de transmission directe S21 de l'atténuateur sélectif en fréquences selon le quatrième mode de réalisation présenté en figure 10 en fonction de la fréquence du signal entrant. A l'exception d'une bande de fréquence autour de F₀ et de F₁, les signaux de toutes les fréquences sont atténués.

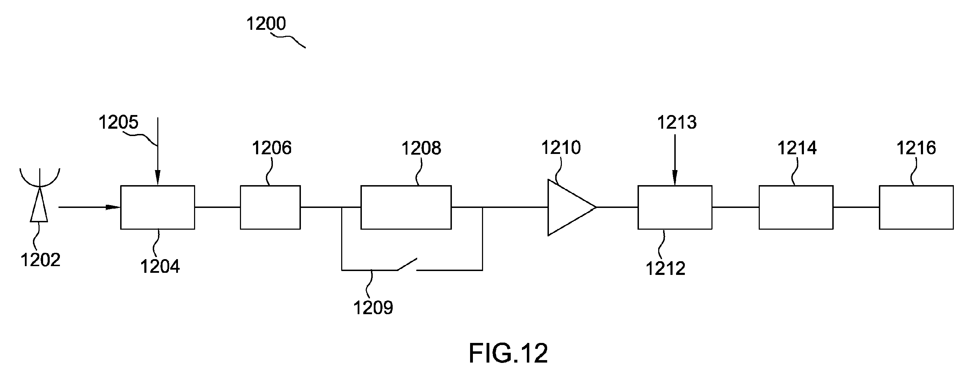

La figure 12 est un synoptique d'une chaîne de réception radiofréquences selon l'invention comportant un atténuateur sélectif en fréquences. La chaîne de réception 1200 comporte un atténuateur programmable 1204 recevant un signal issu d'une antenne 1202. Le niveau d'atténuation appliquée par l'atténuateur programmable 1204 est réglé via un signal de commande 1205. Le signal issu dudit atténuateur 1204 est ensuite reçu par un premier filtre 1206 permettant de conserver seulement une partie du spectre fréquentiel du signal. A ce stade, le signal comprend encore des composantes fréquentielles dont la puissance est trop élevée. Pour diminuer la puissance de ces composantes, le signal issu du premier filtre 1206 est reçu par un atténuateur sélectif en fréquences 1208. L'atténuateur sélectif en fréquences 1208 atténue seulement les composantes fréquentielles émises avec une trop grande puissance. Un amplificateur 1210 est placé en sortie de l'atténuateur sélectif en fréquences 1208, puis le signal issu de cet amplificateur est reçu par un deuxième atténuateur programmable 1212 effectuant un contrôle automatique de gain régulé par un signal de commande 1213. La sortie de l'atténuateur programmable 1212 est reliée à un second filtre 1214, lequel est un filtre anti-repliement permettant de respecter la condition de Shannon avant l'échantillonnage effectué par un CAN 1216 placé en sortie de ce second filtre 1214. L'atténuateur sélectif en fréquences 1208 peut être désactivé dans la chaîne de réception grâce à un module d'aiguillage 1209 permettant de transmettre le signal directement du premier filtre 1206 vers l'amplificateur 1210. Selon un autre mode de réalisation, plusieurs atténuateurs sélectifs 1208 peuvent être placés en cascade. L'atténuateur sélectif en fréquences 1208 est, dans l'exemple, placé parmi les premiers étages de la chaîne de réception 1200 car il n'affecte quasiment pas le facteur de bruit de cette chaîne 1200.

Selon un autre mode de réalisation de la chaîne d'acquisition de signaux, celle-ci est réversible. En d'autres termes, l'atténuateur sélectif 1208 peut également être utilisé alternativement en mode réception et en mode émission afin, par exemple, d'atténuer d'éventuelles raies parasites générées par la chaîne d'acquisition réversible lorsqu'elle est en mode émission. En effet, un atténuateur sélectif 1208 peut fonctionner dans les deux sens de transmission réception/émission, son impédance d'entrée étant égale à son impédance de sortie.

L'atténuateur sélectif en fréquences utilisé dans une chaîne d'acquisition selon l'invention peut être réalisé avec des composants discrets tels que des bobines et des condensateurs, ou avec toute autre technologie permettant l'association de quadripôles. Il requiert peu de composants, ce qui le rend peu encombrant et peu coûteux.

L'un des avantages importants de l'utilisation d'un atténuateur sélectif en fréquences dans une chaîne d'acquisition, est qu'il permet d'obtenir de très bonnes performances d'intermodulation.

Par ailleurs, il est possible d'associer plusieurs atténuateurs sélectifs en série dans une chaîne d'acquisition sans dégrader notablement le facteur de bruit de ladite chaîne, le ROS demeurant proche de 1 pour chaque atténuateur.

Enfin, la structure d'atténuateur peut être appliquée dans des chaînes d'acquisition de signaux acoustiques.

## Revendications

1. Chaîne d'acquisition de signaux, **caractérisée en ce qu'**elle comporte au moins un atténuateur sélectif en fréquences (1208) de la puissance d'un signal entrant, l'atténuateur sélectif comprenant au moins un module atténuateur de puissance (102) pourvu au moins d'une entrée (102a), d'une sortie (102c) et d'un troisième accès (102b, 102d), une paire de modules de réjection, un desdits modules (611, 911) étant centré sur une ou plusieurs fréquences F₀, F₁ et disposé entre l'entrée (102a) et la sortie (102c) du module atténuateur de puissance, et un autre des modules de réjection (612, 912) étant centré sensiblement sur les mêmes fréquences F₀, F₁ et placé entre le troisième accès (102b, 102d) et une masse électrique.

2. Chaîne d'acquisition de signaux selon la revendication 1, **caractérisée en ce que** le module atténuateur de puissance (102) et les modules de réjection (611, 612, 911, 912) de l'atténuateur sélectif en fréquences (1208) sont des quadripôles, l'un des modules de réjection (611, 911) de la paire étant monté en parallèle avec le module atténuateur de puissance (102) pour former un troisième quadripôle, ledit troisième quadripôle étant monté en série avec l'autre module de réjection (612, 912) de la paire.

3. Chaîne d'acquisition de signaux selon l'une des revendications précédentes, **caractérisée en ce que** le premier module de réjection (611, 911) de l'atténuateur sélectif comporte au moins un circuit RLC parallèle et le second module de réjection (612, 912) de l'atténuateur sélectif comporte au moins un circuit RLC série, les fréquences de réjection étant égales aux fréquences d'accord des circuits RLC.

4. Chaîne d'acquisition de signaux selon l'une des revendications précédentes, **caractérisée en ce que** le premier module de réjection (611, 911) de l'atténuateur sélectif comporte au moins un circuit RLC série et le second module de réjection (612, 912) de l'atténuateur sélectif comporte au moins un circuit RLC parallèle, les fréquences de réjection étant égales aux fréquences d'accord des circuits RLC.

5. Chaîne d'acquisition de signaux selon l'une des revendications 3 et 4, **caractérisée en ce qu'**au moins un circuit RLC série et au moins un circuit RLC parallèle comporte une diode à capacité variable pour faire varier la fréquence d'accord F₀.

6. Chaîne d'acquisition de signaux selon l'une des revendications précédentes, **caractérisée en ce qu'**elle est adaptée à recevoir et à traiter des signaux radioélectriques dans la bande HF.

7. Chaîne d'acquisition réversible de signaux selon l'une des revendications précédentes, **caractérisée en ce qu'**elle est adaptée à recevoir et à émettre des signaux transitant par l'atténuateur sélectif en fréquences (1208).
